# EUROPEAN PATENT APPLICATION

(11) **EP 4 734 068 A1**
(43) Date of publication of application: **29.04.2026**
(21) Application number: 24832319.8
(22) Date of filing: 11.06.2024
(51) Int. Cl.: G06T 19/20, G06T 7/70, G06T 17/05, G06T 11/20, G06T 7/11, G06F 3/0481, H04N 23/90, G06T 7/60, G06F 30/13

(54) **ELECTRONIC DEVICE FOR RECOGNIZING STRUCTURE OF SPACE BY USING CAMERA AND CONTROL METHOD THEREOF**

(30) Priority: 26.06.2023 KR 20230082171; 24.08.2023 KR 20230111060
(71) Applicant: Samsung Electronics Co., Ltd., Suwon-si, Gyeonggi-do 16677 (KR)
(72) Inventor: PARK, Hyuncheol, Suwon-si Gyeonggi-do 16677 (KR); KIM, Dowan, Suwon-si Gyeonggi-do 16677 (KR); LEE, Donghyun, Suwon-si Gyeonggi-do 16677 (KR)
(74) Representative: Gulde & Partner
(86) International application number: PCT/KR2024/007935
(87) International publication number: WO 2025/005539

(57) **Abstract**

An electronic device is disclosed. The electronic device may comprise a camera, a display, and at least one processor operatively connected to the camera and the display, wherein the at least one processor is configured to: acquire an image of a space through the camera; on the basis of the image, detect at least one of a horizontal line that is a boundary between a wall and a floor included in the space and a vertical line that is a boundary between walls included in the space; when a vertex of the space is covered by an object, predict a position of the vertex on the basis of the at least one of the horizontal line and the vertical line; and generate an indoor map of the space on the basis of the predicted position of the vertex and the at least one of the horizontal line and the vertical line.

## Description

### [Technical Field]

Embodiments of the disclosure relate to an electronic device for recognizing the structure of space using a camera and a method for controlling the same.

### [Background Art]

Various services and additional functions provided through electronic devices, for example, portable electronic devices such as smartphones, are steadily increasing. In order to enhance the utility value of such electronic devices and meet the diverse needs of users, telecommunications service providers and electronic device manufacturers are competitively developing electronic devices offering diverse functions and differentiating themselves from competitors. Accordingly, the various functions provided through electronic devices are also becoming increasingly sophisticated.

With the advancement of wireless communication technology, devices employing artificial intelligence (AI) have become increasingly prevalent. For example, home appliances connected to a network through Internet of Things (IoT) technology may utilize artificial intelligence (AI). IoT technology may provide intelligent Internet-based services that collect and analyze data generated by devices, thereby creating new value in human life. Through the convergence and integration of existing Internet technologies with various industries, IoT technology may be applied to fields such as smart homes, smart buildings, smart cities, smart vehicles, and smart appliances.

Meanwhile, various home appliances for user convenience are provided in the home. Services are being proposed to facilitate the operation and control of home appliances by utilizing IoT technology. Home network technology may provide users within the home with services through a home network.

For example, home network technology may display objects such as home appliances and/or furniture on a map, based on the structure of the indoor space, providing users with a realistic environment. The map may be generated by recognizing the indoor space.

### [Detailed Description of the Invention]

### [Technical Solution]

According to an embodiment, an electronic device may include a camera, a display, and at least one processor operatively connected to the camera and the display.

According to an embodiment, the at least one processor may acquire an image of a space captured through the camera.

According to an embodiment, the at least one processor may detect at least one of a horizontal line, which is a boundary between a wall and a floor included in the space, or a vertical line, which is a boundary between walls included in the space, based on the image,

According to an embodiment, the at least one processor may predict a position of a vertex of the space, based on at least one of the horizontal line or the vertical line, when the vertex is occluded by an object.

According to an embodiment, the at least one processor may generate an indoor map of the space, based on at least one of the horizontal line or the vertical line and the predicted position of the vertex.

According to an embodiment, a control method of an electronic device may include acquiring an image of a space captured through a camera of the electronic device.

According to an embodiment, the control method of an electronic device may include detecting at least one of a horizontal line, which is a boundary between a wall and a floor included in the space, or a vertical line, which is a boundary between walls included in the space, based on the image.

According to an embodiment, the control method of an electronic device may include predicting a position of a vertex of the space, based on at least one of the horizontal line or the vertical line, when the vertex is occluded by an object.

According to an embodiment, the control method of an electronic device may include generating an indoor map of the space, based on at least one of the horizontal line or the vertical line and the predicted position of the vertex.

According to an embodiment, in a non-transitory computer-readable recording medium storing one or more programs, the one or more programs may include instructions that cause an electronic device, wherein, according to an embodiment, the at least one processor, to acquire an image of a space captured through a camera of the electronic device.

According to an embodiment, the one or more programs may include instructions that cause the electronic device to detect at least one of a horizontal line, which is a boundary between a wall and a floor included in the space, or a vertical line, which is a boundary between walls included in the space, based on the image,

According to an embodiment, the one or more programs may include instructions that cause the electronic device to predict a position of a vertex of the space, based on at least one of the horizontal line or the vertical line, when the vertex is occluded by an object.

According to an embodiment, the one or more programs may include instructions that cause the electronic device to generate an indoor map of the space, based on at least one of the horizontal line or the vertical line and the predicted position of the vertex.

### [Brief Description of Drawings]

FIG. 1 is a block diagram of an electronic device in a network environment according to various embodiments.
FIG. 2 is a diagram illustrating a brief configuration of an electronic device according to an embodiment.
FIG. 3 is a flowchart illustrating an indoor map generation operation of an electronic device according to an embodiment.
FIG. 4 is a diagram illustrating an operation of generating an indoor map using a camera of an electronic device according to an embodiment.
FIG. 5 is a diagram illustrating a camera initialization operation of an electronic device for space recognition according to an embodiment.
FIG. 6A is a diagram illustrating an operation of providing a space recognition result of an electronic device and generating an indoor map, based on received user input, according to an embodiment.
FIG. 6B is a diagram illustrating an operation of providing a space recognition result of an electronic device and generating an indoor map, based on received user input, according to an embodiment.
FIG. 7 is a diagram illustrating a space recognition operation of an electronic device according to an embodiment.
FIG. 8A is a diagram illustrating a space recognition operation of an electronic device according to an embodiment.
FIG. 8B is a diagram illustrating a space recognition operation of an electronic device according to an embodiment.
FIG. 9A is a diagram illustrating a space recognition operation of an electronic device according to an embodiment.
FIG. 9B is a diagram illustrating a space recognition operation of an electronic device according to an embodiment.
FIG. 10 is a diagram illustrating an operation of displaying a space recognition result of an electronic device according to an embodiment.
FIG. 11 is a diagram illustrating an operation of displaying an indoor map generated based on space recognition of an electronic device according to an embodiment.

### [Mode for Carrying out the Invention]

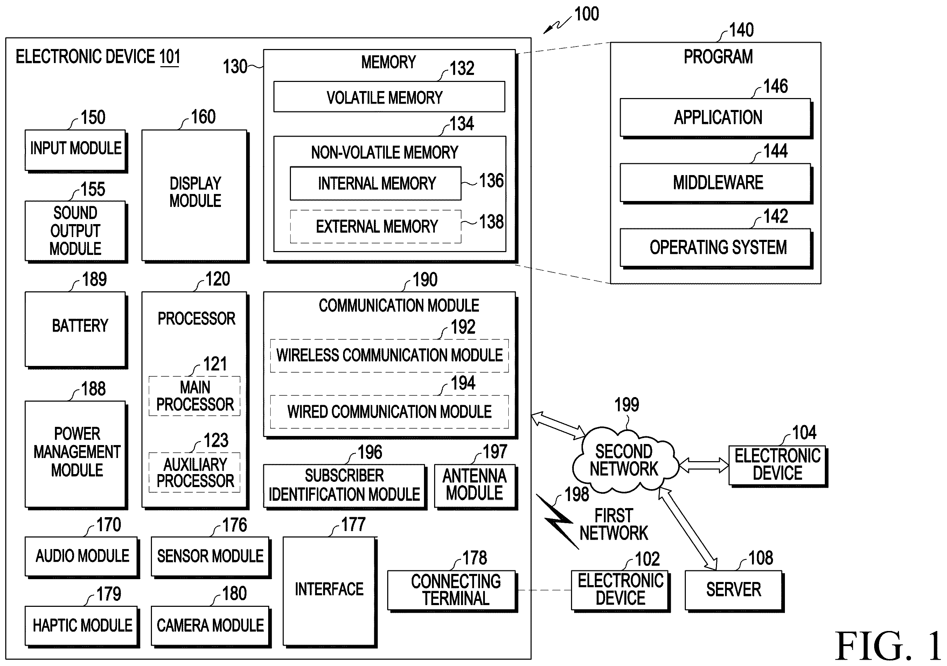

FIG. 1 is a block diagram illustrating an electronic device 101 in a network environment 100 according to various embodiments. Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to an embodiment, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

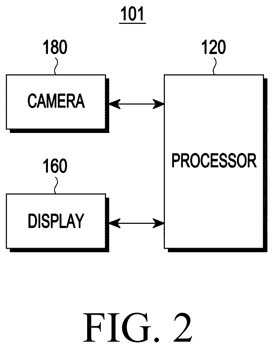

FIG. 2 is a diagram illustrating a brief configuration of an electronic device according to an embodiment.

Referring to FIG. 2, an electronic device 101 (e.g., the electronic device 101 in FIG. 1) may include a camera 180 (e.g., the camera module 180 in FIG. 1), a display 160 (e.g., the display module 160 in FIG. 1), and a processor 120 (e.g., the processor 120 in FIG. 1).

According to an embodiment, the processor 120 may display an image of an actual space captured by the camera 180 on the display 160.

According to an embodiment, the camera 180 may be a stereo camera including two or more cameras capable of measuring a distance between the electronic device and an object. According to an embodiment, the processor 120 may arrange a grid on the floor area of the space included in the image, based on the stereo camera. The grid may be configured such that a plurality of horizontal straight lines and a plurality of vertical straight lines are arranged at predetermined equal intervals, and the plurality of horizontal straight lines and the plurality of vertical straight lines may be perpendicular to each other.

According to an embodiment, the processor 120 may configure a position reference and/or a distance reference by arranging the grid on the floor area included in the image. For example, even when the position and orientation of the electronic device 101 change and the area of the actual space being captured changes, the processor 120 may identify the relative position of the actual space included in each image, based on the grid. According to an embodiment, the grid may or may not be displayed in the image.

According to an embodiment, the processor 120 may detect (or extract or recognize) at least one of a horizontal line and a vertical line included in the image. For example, the horizontal line may include a boundary between the floor and wall of the space. For example, the vertical line may include a boundary between walls of the space.

According to an embodiment, when the processor 120 detects a plurality of horizontal lines in the image, it may display the plurality of horizontal lines on the display 160. According to an embodiment, among the plurality of horizontal lines, the processor 120 may highlight a horizontal line estimated to be the boundary between the floor and the wall.

According to an embodiment, when a user input is received to select a horizontal line different from the highlighted horizontal line from among the plurality of horizontal lines, the processor 120 may generate an indoor map, based on the selected horizontal line rather than the previously highlighted horizontal line. According to an embodiment, the processor 120 may remove the highlight effect from the previously highlighted horizontal line and then highlight the selected horizontal line. According to an embodiment, the operation of highlighting one of the plurality of lines and the operation of changing the highlighted line, based on user input, may also be applied to the vertical line.

According to an embodiment, when a horizontal line and/or a vertex of the space is occluded by an object, the processor 120 may predict (or acquire, calculate, estimate, identify, or determine) the horizontal line of the occluded area, based on at least one of the horizontal line or vertical line in the unoccluded area.

According to an embodiment, the processor 120 may acquire length information of horizontal lines, based on the captured image of the space acquired by the stereo camera. For example, the processor 120 may acquire length information of horizontal lines included in the actual space, based on the minimum interval configured between the plurality of horizontal or vertical straight lines included in the grid and the number of intervals included in the horizontal lines.

According to an embodiment, based on detecting a closed curve including the detected horizontal lines and the plurality of predicted horizontal lines, the processor 120 may generate an indoor map of the space, based on the detected horizontal lines and the plurality of predicted horizontal lines. For example, the indoor map of the space may include information related to the structure and area of the space (e.g., the horizontal and vertical lengths of the floor).

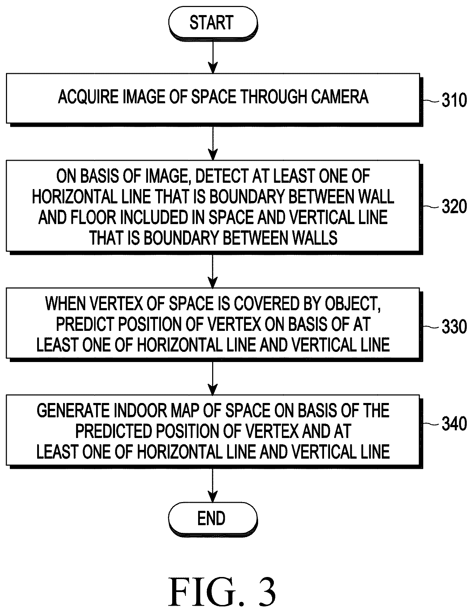

According to an embodiment, the operation in which the electronic device 101 recognizes the structure of the space using the camera 180 will be described in more detail with reference to FIGS. 3 to 11 below.

FIG. 3 is a flowchart illustrating an indoor map generation operation of an electronic device according to an embodiment.

Referring to FIG. 3, an electronic device (e.g., the electronic device 101 in FIG. 1, the processor 120 in FIG. 1, the electronic device 101 in FIG. 2, or the processor 120 in FIG. 2) may acquire an image of a space captured by a camera (e.g., the camera module 180 in FIG. 1 or the camera 180 in FIG. 2) in operation 310.

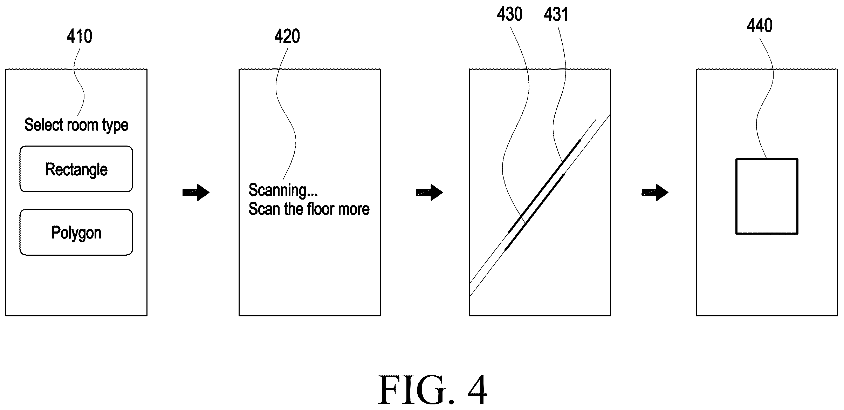

According to an embodiment, the electronic device may display, on a display (e.g., the display module 160 in FIG. 1 or the display 160 in FIG. 2), a user interface (UI) for receiving a user input for selecting the shape of the space before capturing the space through the camera. For example, as illustrated in FIG. 4 below, the electronic device may display a user interface for selecting whether the space has an orthogonal, curved, or diagonal structure in order to generate an indoor map (e.g., an indoor floor plan).

In this way, based on receiving the rough structure of the space through the user interface, the electronic device may generate a more accurate indoor map.

According to an embodiment, an electronic device may perform a camera initialization operation to recognize space. For example, the camera may be a stereo camera including two or more cameras capable of measuring the distance between the electronic device and an object.

According to an embodiment, the camera initialization operation may include an operation of arranging grid-shaped reference lines in an area corresponding to the floor within an image captured by the stereo camera. The grid may be configured such that a plurality of horizontal straight lines and a plurality of vertical straight lines are arranged at predetermined equal intervals, and the plurality of horizontal straight lines and the plurality of vertical straight lines may be perpendicular to each other.

According to an embodiment, the electronic device may configure a position reference and/or a distance reference by arranging the grid on the floor area included in the image. For example, even when the position and orientation of the electronic device change and the area of the actual space being captured changes, the electronic device may identify the relative position of the actual space included in each image, based on the grid. According to an embodiment, the grid may or may not be displayed in the image.

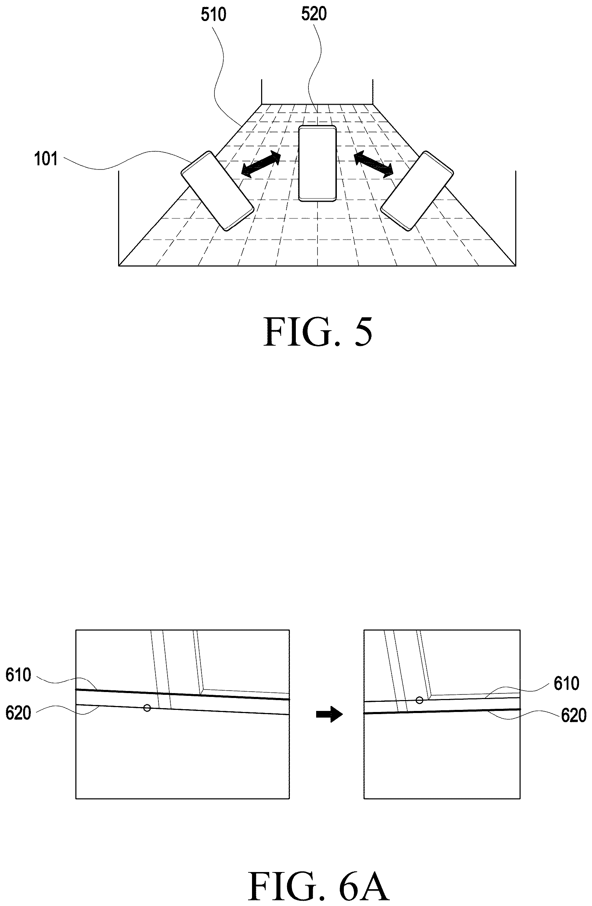

According to an embodiment, the camera initialization operation will be described in more detail with reference to FIG. 5 below.

According to an embodiment, an electronic device may display an image of an indoor space acquired through a camera on a display (e.g., the display module 160 in FIG. 1).

According to an embodiment, in operation 320, the electronic device may detect (or extract or recognize) at least one of a horizontal line, which is a boundary between a wall and a floor in the space, or a vertical line, which is a boundary between walls, based on the image.

According to an embodiment, an electronic device may display at least one of the horizontal line and the vertical line.

According to an embodiment, when a plurality of horizontal lines are detected in a boundary area between the floor and the wall, the electronic device may display the detected horizontal lines in the image. According to an embodiment, the electronic device may highlight a horizontal line estimated to be a boundary between the floor and the wall, among the plurality of horizontal lines.

For example, when a plurality of horizontal lines are detected, the electronic device may select one of the plurality of horizontal lines, based on the boundary of an area where the grid is arranged.

For example, when a plurality of horizontal lines are detected in an image obtained by capturing an area of an indoor space, the electronic device may select one of the plurality of horizontal lines, based on at least one line selected from another area of the indoor space.

According to an embodiment, when a user input is received to select a horizontal line different from the highlighted horizontal line from among the plurality of horizontal lines, the electronic device may generate an indoor map, based on the selected horizontal line rather than the previously highlighted horizontal line. According to an embodiment, the electronic device may remove the highlight effect from the previously highlighted horizontal line and then highlight the selected horizontal line. According to an embodiment, the operation of highlighting one of the plurality of lines, the operation of changing the highlighted line, based on user input, and the operation of generating an indoor map, based on the user-selected line, may also be applied to the vertical line.

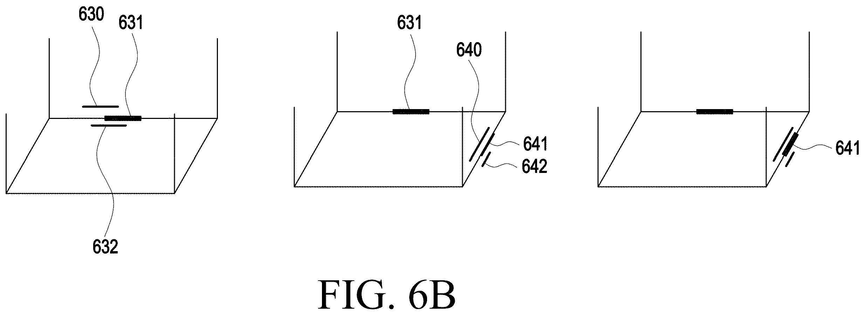

According to an embodiment, the operations of displaying the plurality of detected lines and the operation of generating an indoor map, based on the line selected by the user input, will be described later with reference to FIGS. 6A and 6B.

According to an embodiment, in operation 330, when a vertex of the space is occluded by an object, the electronic device may predict (or acquire, calculate, estimate, identify, or determine) the position of the vertex, based on at least one of the horizontal line or vertical line.

According to an embodiment, the electronic device may predict an extension line of the detected horizontal line or an extension line of the detected vertical line. According to an embodiment, the electronic device may predict the position of an intersection of two or more of the extension lines of the horizontal lines or the extension lines of the vertical lines as the position of the vertex.

For example, when a vertex of the space is occluded by an object, but some of the plurality of horizontal lines, which constitute the boundary between the floor and the wall, are detected, the position of an intersection may be predicted based on the extension lines of some detected lines.

For example, the electronic device may predict information (e.g., coordinate information of an intersection) related to the position of an intersection, based on the grid arranged on the floor plane. According to an embodiment, the electronic device may acquire the distance between two adjacent vertices (or the length of the horizontal line connecting two vertices), based on the grid arranged on the floor plane.

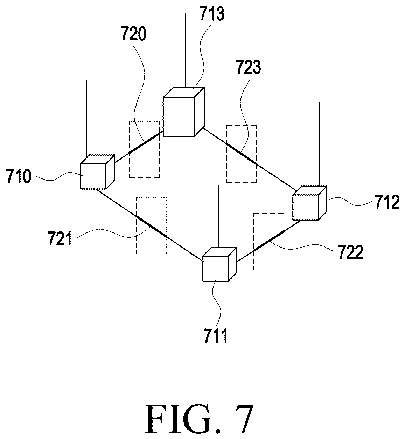

According to an embodiment, the operations of predicting the extension line of the line and predicting the vertex in the occluded portion will be described in more detail later with reference to FIG. 7.

According to an embodiment, when one of the plurality of horizontal lines, which constitute the boundary between the floor and the wall, is entirely occluded by an object, the electronic device may generate a virtual line, based on two or more of the detected horizontal lines or vertical lines. According to an embodiment, the electronic device may predict an extension line of the horizontal line or an extension line of the vertical line. According to an embodiment, the position of an intersection between one of the extension line of the horizontal line or the extension line of the vertical line and the virtual line may be predicted as the position of the vertex.

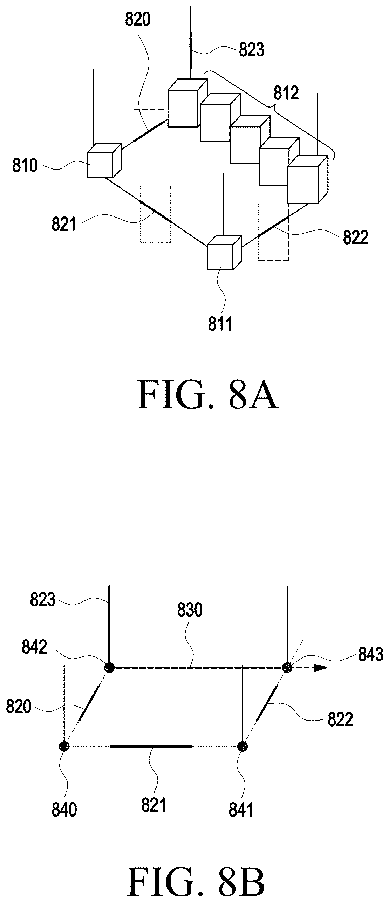

According to an embodiment, the operations of predicting the extension line of the line and predicting the vertex in the occluded portion will be described in more detail later with reference to FIGS. 8A and 8B.

According to an embodiment, when one of the plurality of horizontal lines, which constitute the boundary between the floor and the wall, is entirely occluded by an object, the electronic device may detect the floor area included in the image. For example, the electronic device may detect the floor area, based on a change in distance between the electronic device and an object (e.g., a floor or a wall) using the stereo camera. According to an embodiment, the electronic device may predict the positions of intersections between two or more of the floor area and the vertical lines and the floor area as the positions of the vertices.

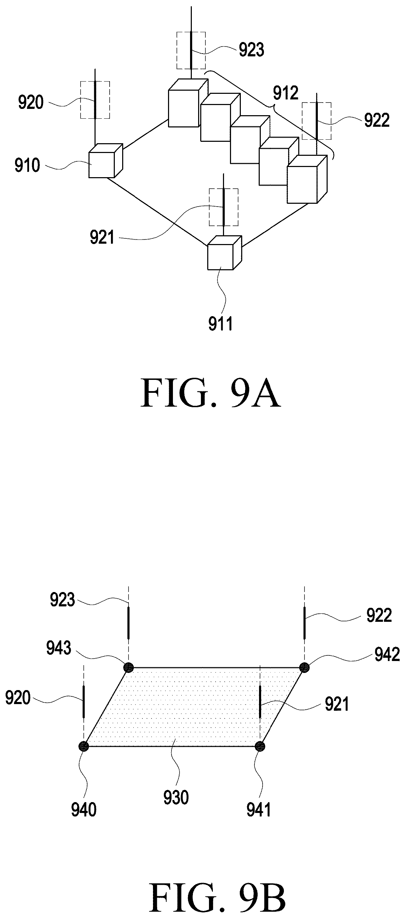

According to an embodiment, an embodiment of predicting the intersection of the floor area and the vertical line will be described in more detail later with reference to FIGS. 9A and 9B.

According to an embodiment, after receiving a user input for selecting one or more lines, the electronic device may display a message prompting movement to capture another area of the space. For example, when the electronic device does not move for a configured period of time after detecting all horizontal or vertical lines associated with a specific area of the indoor space, the electronic device may display a message including text prompting movement to another area, an arrow indicating a movement guiding direction, and/or a highlight on the edge area of the display corresponding to the movement guiding direction.

According to an embodiment, the electronic device may acquire length information of horizontal lines, based on the captured image of the space acquired by the stereo camera. For example, the electronic device may acquire length information of horizontal lines included in the actual space, based on the minimum interval configured between the plurality of horizontal or vertical straight lines included in the grid and the number of intervals included in the horizontal lines.

According to an embodiment, in operation 340, the electronic device may generate an indoor map of the space, based on at least one of the horizontal or vertical lines and the predicted position of the vertex.

According to an embodiment, the electronic device may predict the plurality of horizontal lines occluded by the object, based on the predicted position of the vertex.

According to an embodiment, based on detecting a closed curve including the detected horizontal lines and the plurality of predicted horizontal lines, the electronic device may generate an indoor map of the space, based on the detected horizontal lines and the plurality of predicted horizontal lines. For example, the indoor space may be defined as a closed curve in a polygonal shape, or a closed curve including curves. Accordingly, when a closed curve including the detected horizontal lines and the plurality of predicted horizontal lines is detected, the electronic device may generate an indoor map of the space in the form of the detected closed curve.

In this way, the structure of the space may be predicted even by capturing only a portion of the space boundary, rather than the entire boundary, using a camera, and a more accurate indoor map may be generated by receiving user input.

FIG. 4 is a diagram illustrating an operation of generating an indoor map using a camera of an electronic device according to an embodiment.

Referring to FIG. 4, an electronic device (e.g., the electronic device 101 in FIG. 1, the processor 120 in FIG. 1, the electronic device 101 in FIG. 2, or the processor 120 in FIG. 2) may display a user interface 410 for selecting a space shape on a display (e.g., the display module 160 in FIG. 1 or the display 160 in FIG. 2).

For example, the user interface 410 for selecting a space shape may allow selection of whether the space has an orthogonal (e.g., rectangular) structure or a polygonal structure, which may include a curved shape of an oblique shape.

In this way, based on receiving the rough structure of the space through the user interface 410, the electronic device may generate a more accurate indoor map.

According to an embodiment, the electronic device may omit the operation of displaying the user interface 410 for selecting the space shape.

According to an embodiment, the electronic device may perform an initialization operation to recognize the space through a camera (e.g., the camera module 180 in FIG. 1 or the camera 180 in FIG. 2). According to an embodiment, the electronic device may display a user interface 420 indicating that the initialization operation is being performed when performing the initialization operation. According to an embodiment, the camera may be a stereo camera including two or more cameras capable of measuring the distance between the electronic device and an object.

For example, the camera initialization operation may include an operation of guiding the user to move the electronic device left and right and arranging grid-like reference lines in an area corresponding to the floor within an image captured by the stereo camera while the electronic device is moving. The grid may be configured such that a plurality of horizontal straight lines and a plurality of vertical straight lines are arranged at predetermined equal intervals, and the plurality of horizontal straight lines and the plurality of vertical straight lines may be perpendicular to each other.

According to an embodiment, the electronic device may configure a position reference and/or a distance reference by arranging the grid on the floor area included in the image. For example, even when the position and orientation of the electronic device change and the area of the actual space being captured changes, the electronic device may identify the relative position of the actual space included in each image, based on the grid. According to an embodiment, the grid may or may not be displayed in the image.

According to an embodiment, the camera initialization operation will be described in more detail below with reference to FIG. 5.

According to an embodiment, the electronic device may detect (or extract or recognize) one or more horizontal line 430 and 431 and/or at least one vertical line included in the space, based on the image captured by the camera. For example, one or more horizontal lines 430 and 431 may include a horizontal line 430 that is a boundary between a wall and a floor within the space. According to an embodiment, at least one vertical line may include a vertical line that is a boundary between walls.

According to an embodiment, the electronic device may display one or more horizontal lines 430 and 431 and/or at least one vertical line detected within the image captured by the camera.

According to an embodiment, the electronic device may highlight the horizontal line 430 that is estimated to be a boundary between the floor and the wall, among the plurality of horizontal lines 430 and 431.

For example, when a plurality of horizontal lines are detected, the electronic device may select one of the plurality of horizontal lines, based on the boundary of an area where the grid is arranged.

For example, when a plurality of horizontal lines 430 and 431 are detected in an image obtained by capturing an area of an indoor space, the electronic device may select one horizontal line 430 of the plurality of horizontal lines, based on at least one line selected from another area of the indoor space.

According to an embodiment, when a user input is received to select a horizontal line different from the highlighted horizontal line 430 from among the plurality of horizontal lines 430 and 431, the electronic device may generate an indoor map, based on the selected horizontal line rather than the previously highlighted horizontal line. According to an embodiment, the electronic device may remove the highlight effect from the previously highlighted horizontal line and then highlight the selected horizontal line. According to an embodiment, the operation of highlighting one of the plurality of lines, the operation of changing the highlighted line, based on user input, and the operation of generating an indoor map, based on the user-selected line, may also be applied to the vertical line.

According to an embodiment, the operation of displaying the plurality of detected lines and the operation of generating an indoor map, based on the line selected through user input, will be described below with reference to FIGS. 6A and 6B.

According to an embodiment, the electronic device may determine one of the plurality of horizontal lines within the area captured by the camera and store the height of the determined horizontal line. For example, the height of the horizontal line may be the distance between the electronic device and the horizontal line in the plane direction of the floor area including the horizontal line (e.g., a direction perpendicular to all straight lines included in the floor area).

According to an embodiment, the electronic device may highlight the determined horizontal line. This allows the user to identify the highlighted horizontal line and then move the electronic device to capture another area.

According to an embodiment, when the electronic device does not move for a configured period of time after detecting all horizontal or vertical lines associated with a specific area of the indoor space, the electronic device may display a message including text prompting movement to another area, an arrow indicating a movement guiding direction, and/or a highlight on the edge area of the display corresponding to the movement guiding direction.

According to an embodiment, when the plurality of detected horizontal lines are not connected and are partially occluded by an object disposed at a vertex of the space, the electronic device may predict the position of the vertex in the occluded portion, based on the detected horizontal lines and/or vertical lines.

According to an embodiment, the electronic device may predict an extension line of the detected horizontal line or an extension line of the detected vertical line. According to an embodiment, the electronic device may predict the position of an intersection of two or more of the extension lines of the horizontal lines or the extension lines of the vertical lines as the position of the vertex.

For example, when a vertex of the space is occluded by an object, but some of the plurality of horizontal lines, which constitute the boundary between the floor and the wall, are detected (e.g., when four or more horizontal lines are detected), the position of an intersection may be predicted based on the extension lines of some detected lines.

For example, the electronic device may predict information (e.g., coordinate information of an intersection) related to the position of an intersection, based on the grid arranged on the floor plane. According to an embodiment, the electronic device may acquire the distance between two adjacent vertices (or the length of the horizontal line connecting two vertices), based on the grid arranged on the floor plane.

According to an embodiment, the operations of predicting the extension line of a line and predicting the vertex of the occluded portion will be described in more detail below with reference to FIG. 7.

According to an embodiment, when one of the plurality of horizontal lines, which constitute the boundary between the floor and the wall, is entirely occluded by an object (e.g., when four or more horizontal or vertical lines are detected), the electronic device may generate a virtual line, based on two or more of the detected horizontal lines or vertical lines. According to an embodiment, the electronic device may predict an extension line of the horizontal line or an extension line of the vertical line. According to an embodiment, the position of an intersection between one of the extension line of the horizontal line or the extension line of the vertical line and the virtual line may be predicted as the position of the vertex.

According to an embodiment, the operations of predicting the extension line of a line and predicting the vertex in the occluded portion will be described in more detail later with reference to FIGS. 8A and 8B.

According to an embodiment, when one of the plurality of horizontal lines, which constitute the boundary between the floor and the wall, is entirely occluded by an object (e.g., when four or more vertical lines are detected), the electronic device may detect a floor area included in the image. For example, the electronic device may detect the floor area, based on a change in distance between the electronic device and an object (e.g., a floor or a wall) using the stereo camera. According to an embodiment, the electronic device may predict the positions of intersections between two or more of the floor area and the vertical lines and the floor area as the positions of the vertices.

According to an embodiment, an embodiment of predicting the intersection between the floor area and the vertical line will be described in more detail later with reference to FIGS. 9A and 9B.

According to an embodiment, when a floor area includes height differences, such as a stair or ramp, the electronic device may detect horizontal lines having different heights from the area with height differences. According to an embodiment, the electronic device may project the remaining horizontal lines at the height of one of the plurality of horizontal lines having different heights, or project the plurality of horizontal lines at a configured height, thereby correcting them into a single horizontal line. For example, in the case of stairs, the correction may be made by adding two horizontal lines of different heights, based on the step. For example, in the case of a ramp, the boundary between the ramp and a wall may be vertically projected at a specific height, thereby acquiring a horizontal line corresponding to the ramp. According to an embodiment, the correction may be made by adding a horizontal line corresponding to the ramp between two horizontal lines separated by the ramp.

According to an embodiment, the electronic device may generate an indoor map (e.g., a floor plan), based on the corrected horizontal line.

FIG. 5 is a diagram illustrating a camera initialization operation of an electronic device for space recognition according to an embodiment.

Referring to FIG. 5, an electronic device 101 (e.g., the electronic device 101 in FIG. 1, the processor 120 in FIG. 1, the electronic device 101 in FIG. 2, or the processor 120 in FIG. 2) may perform an initialization operation to recognize a space 510 using a camera (e.g., the camera module 180 in FIG. 1 or the camera 180 in FIG. 2). According to an embodiment, the camera may be a stereo camera including two or more cameras capable of measuring the distance between the electronic device and an object.

According to an embodiment, the camera initialization operation may include guiding the user to move the electronic device 101 left and right and acquiring a distance to an object (e.g., a floor or wall) within the space 510 through an image captured by the stereo camera while the electronic device 101 is moving.

According to an embodiment, the electronic device 101 may also acquire the distance to an object within the space 510 using a proximity sensor. According to an embodiment, when the electronic device 101 does not include a proximity sensor for distance measurement, the electronic device 101 may acquire the distance to an object within the space 510 using only the camera.

According to an embodiment, the electronic device 101 may distinguish between a floor area and a wall area within the space 510, based on the distance to the object. According to an embodiment, the electronic device 101 may include an operation of arranging reference lines in the form of a grid 520 in an area corresponding to the floor. The grid 520 may be configured such that a plurality of horizontal straight lines and a plurality of vertical straight lines are arranged at predetermined equal intervals, and the plurality of horizontal straight lines and the plurality of vertical straight lines may be perpendicular to each other.

According to an embodiment, the electronic device 101 may configure a position reference and/or a distance reference by arranging the grid 520 on the floor area included in the image. For example, even when the position and orientation of the electronic device 101 change and the area of the actual space being captured changes, the electronic device may identify the relative position of the actual space included in each image, based on the grid. According to an embodiment, the grid may or may not be displayed in the image.

Although FIG. 5 shows the floor area having the same height in the space 510, but the disclosure is not limited thereto, and the floor area may include stairs and/or ramps.

According to an embodiment, when performing the initialization operation, the electronic device may display a user interface (e.g., the interface 420 in FIG. 4) indicating that the initialization operation is being performed on a display (e.g., the display module 160 in FIG. 1 or the display 160 in FIG. 2).

FIG. 6A is a diagram illustrating an operation of providing a space recognition result of an electronic device and generating an indoor map, based on received user input, according to an embodiment.

Referring to FIG. 6A, when an image captured by a camera (e.g., the camera module 180 in FIG. 1 or the camera 180 in FIG. 2) includes a plurality of horizontal lines 610 and 620, an electronic device (e.g., the electronic device 101 in FIG. 1, the processor 120 in FIG. 1, the electronic device 101 in FIG. 2, or the processor 120 in FIG. 2) may display the plurality of horizontal lines 610 and 620 together with the image on a display (e.g., the display module 160 in FIG. 1 or the display 160 in FIG. 2). Although only the plurality of horizontal lines 610 and 620 are displayed in FIG. 6A, when a vertical line is detected, the vertical line may also be displayed.

According to an embodiment, the electronic device may highlight the horizontal line 610 that is estimated to be the boundary between a floor and a wall, among the plurality of horizontal lines 610 and 620.

For example, when a plurality of horizontal lines 610 and 620 are detected, the electronic device may select one horizontal line 610 from among the plurality of lines, based on the boundary of an area where the grid is arranged.

For example, when a plurality of horizontal lines 610 and 620 are detected in an image obtained by capturing an area of an indoor space, the electronic device may select one horizontal line 610 from among the plurality of lines, based on at least one line selected from another area of the indoor space.

According to an embodiment, the operation of selecting one of the plurality of lines, based on the determined line in another area of the space, will be described in more detail below with reference to FIG. 6B.

According to an embodiment, when the highlighted horizontal line 610, among the plurality of horizontal lines 610 and 620, is not the boundary between the floor and the wall, the user may select another horizontal line 620.

According to an embodiment, when a user input is received to select the horizontal line 620 other than the highlighted horizontal line 610 from among the plurality of horizontal lines 610 and 620, the electronic device may generate an indoor map (e.g., a floor plan), based on the selected horizontal line 620 rather than the previously highlighted horizontal line 610.

According to an embodiment, the electronic device may remove the highlight effect from the previously highlighted horizontal line 610 and then highlight the horizontal line 620 selected by the user input.

According to an embodiment, the operation of highlighting one of the plurality of lines, the operation of changing the highlighted line, based on user input, and generating an indoor map, based on the user-selected line, may also be applied to the vertical line.

FIG. 6B is a diagram illustrating an operation of providing a space recognition result of an electronic device and generating an indoor map, based on received user input, according to an embodiment.

Referring to FIG. 6B, the electronic device may detect a plurality of lines (e.g., horizontal lines) 630, 631, and 632 included in a first image obtained by capturing an area of a space, and display them on the first image.

According to an embodiment, the electronic device, based on receiving a user input for selecting a first line 631 from among the plurality of lines 630, 631, and 632, may determine the first line 631 as the boundary between the floor and the wall.

According to an embodiment, the electronic device may store the height of the first line 631. For example, the height of a line may be the distance between the electronic device and the line in the plane direction of the floor area including the line (e.g., a direction perpendicular to all straight lines included in the floor area).

According to an embodiment, in the state in which the first line 631 is determined, the electronic device may display a plurality of lines (e.g., horizontal lines) 640, 641, and 642 included in a second image, which is obtained by capturing another area within the space, on the second image.

According to an embodiment, the electronic device, based on the height of the first line 631, may automatically select a second line 641 as the boundary between the floor and the wall from among the plurality of lines 640, 641, and 642 included in the second image. For example, the electronic device may select the second line 641, which has a height closest to that of the first line 631, from among the plurality of lines 640, 641, and 642 included in the second image.

According to an embodiment, the electronic device may highlight and display the second line 641. According to an embodiment, when no user input is received for a configured period of time after highlighting and displaying the second line 641 or when the electronic device is moved to capture another area, the electronic device may determine the second line 641 as the boundary between the floor and the wall.

According to an embodiment, when the user selects a line other than the highlighted second line 641 from among the plurality of lines 640, 641, and 642 after highlighting and displaying the second line 641, the electronic device may determine the line selected by the user input as the boundary between the floor and the wall. According to an embodiment, the electronic device may remove the highlighting of the second line 641 and highlight the line selected by the user input.

FIG. 7 is a diagram illustrating a space recognition operation of an electronic device according to an embodiment.

Referring to FIG. 7, an electronic device (e.g., the electronic device 101 in FIG. 1, the processor 120 in FIG. 1, the electronic device 101 in FIG. 2, or the processor 120 in FIG. 2) may capture images of areas of space using a camera (e.g., the camera module 180 in FIG. 1 or the camera 180 in FIG. 2). For example, respective vertices of the space may be occluded by a plurality of objects 710, 711, 712, and 713.

According to an embodiment, the electronic device may detect a plurality of horizontal lines 720, 721, 722, and 723 through the captured images. For example, the plurality of horizontal lines 720, 721, 722, and 723 may be selected by the electronic device or by user input.

According to an embodiment, when the plurality of detected horizontal lines 720, 721, 722, and 723 are not connected and partially occluded by the objects 710, 711, 712, and 713 disposed at vertices of the space, the electronic device may predict the positions of the occluded vertices, based on the detected horizontal lines 720, 721, 722, and 723.

According to an embodiment, the electronic device may predict extension lines of the detected horizontal lines 720, 721, 722, and 723. According to an embodiment, the electronic device may predict the positions of two or more intersections among the extension lines of the horizontal lines 720, 721, 722, and 723 as the positions of the vertices.

For example, the electronic device may predict information (e.g., coordinate information of an intersection) related to the position of an intersection, based on the grid arranged on the floor plane.

For example, the electronic device may predict the position of an intersection between the extension line of a first horizontal line 720 and the extension line of a second horizontal line 721 as the position of a first vertex occluded by a first object 710.

For example, the electronic device may predict the position of an intersection of the extension line of the second horizontal line 721 and the extension line of a third horizontal line 722 as the position of a second vertex occluded by a second object 711.

For example, the electronic device may predict the position of an intersection of the extension line of the third horizontal line 722 and the extension line of a fourth horizontal line 723 as the position of a third vertex occluded by a third object 712.

For example, the electronic device may predict the position of an intersection of the extension line of the fourth horizontal line 723 and the extension line of the first horizontal line 720 as the position of a fourth vertex occluded by a fourth object 713.

According to an embodiment, the electronic device may predict the plurality of horizontal lines occluded by the objects, based on the predicted positions of vertices.

According to an embodiment, based on detecting a closed curve including the detected horizontal lines and the predicted horizontal lines, the electronic device may generate an indoor map (e.g., a floor plan) of the space, based on the detected horizontal lines and the predicted horizontal lines. For example, the indoor space may be defined as a closed curve in a polygonal shape, or a closed curve including curves. Accordingly, when a closed curve including the detected horizontal lines and the predicted horizontal lines is detected, the electronic device may generate an indoor map of the space in the form of the detected closed curve.

According to an embodiment, the electronic device may acquire the distance between adjacent vertices, based on the predicted position coordinates of the vertices.

According to an embodiment, the electronic device may acquire the distance between two adjacent vertices (or the length of the horizontal line connecting two vertices), based on the grid arranged on the floor plane.

FIG. 8A is a diagram illustrating a space recognition operation of an electronic device according to an embodiment.

FIG. 8B is a diagram illustrating a space recognition operation of an electronic device according to an embodiment.

Referring to FIG. 8A, an electronic device (e.g., the electronic device 101 in FIG. 1, the processor 120 in FIG. 1, the electronic device 101 in FIG. 2, or the processor 120 in FIG. 2) may capture images of areas of a space through a camera (e.g., the camera module 180 in FIG. 1 or the camera 180 in FIG. 2). For example, respective vertices and the entirety of one of a plurality of horizontal lines, which constitute the boundary between a floor and a wall, in a space may be occluded by a plurality of objects 810, 811, and 812.

According to an embodiment, when the electronic device is unable to detect a horizontal line in an area due to the object 812, the electronic device may detect a plurality of horizontal lines 820, 821, 822 and a vertical line 823 from the captured images. For example, the plurality of horizontal lines 820, 821, and 822 and the vertical line 823 may be selected by the electronic device or by user input. For example, the vertical line 823 may be at least one of the vertical lines orthogonal to the undetectable horizontal line.

According to an embodiment, when the plurality of detected horizontal lines 820, 821, and 822 and vertical lines 823 are not connected and are partially occluded by the objects 810, 811, and 812 disposed at vertices of the space, the electronic device may predict the positions of the vertices of the occluded portions, based on the detected horizontal lines 820, 821, and 822 and/or vertical lines 823.

According to an embodiment, as illustrated in FIG. 8B, the electronic device may predict extension lines of the detected horizontal lines 820, 821, and 822 or extension lines of the detected vertical lines 823. According to an embodiment, the electronic device may predict the positions of two or more intersections among the extension lines of the horizontal lines 820, 821, and 822 or the extension lines of the vertical lines 823 as the positions of the vertices.

For example, the electronic device may predict information (e.g., coordinate information of an intersection) related to the position of an intersection, based on the grid arranged on the floor plane.

For example, the electronic device may predict the position of an intersection between the extension line of a first horizontal line 820 and the extension line of a second horizontal line 821 as the position of a first vertex 840 occluded by a first object 810.

For example, the electronic device may predict the position of an intersection between the extension line of the second horizontal line 821 and the extension line of a third horizontal line 822 as the position of a second vertex 841 occluded by a second object 811.

For example, the electronic device may predict the position of an intersection of the extension line of the first horizontal line 820 and the extension line of a first vertical line 823 as the position of a third vertex 842 occluded by a third object 812.

According to an embodiment, the electronic device may generate a virtual line 830, based on two or more of the detected horizontal lines 820, 821, 822 or vertical lines 823, as illustrated in FIG. 8B. For example, the electronic device may generate a virtual line 830 parallel to the second horizontal line 821. For example, the virtual line 830 may have the same height as at least one of the first horizontal line 820 to the third horizontal line 822.

According to an embodiment, the virtual line 830 may pass through the third vertex 842.

According to an embodiment, the position of an intersection between one of the extension lines of the horizontal lines 820, 821, and 822 or the extension lines of the vertical lines 823 and the virtual line 830 may be predicted as the position of a fourth vertex 843.

According to an embodiment, the electronic device may predict the plurality of horizontal lines occluded by the objects, based on the positions of the predicted vertices 840, 841, 842, and 843.

According to an embodiment, based on detecting a closed curve including the detected horizontal lines and the predicted horizontal lines, the electronic device may generate an indoor map (e.g., a floor plan) of the space, based on the detected horizontal lines and the predicted horizontal lines. For example, the indoor space may be defined as a closed curve in a polygonal shape, or a closed curve including curves. Accordingly, when a closed curve including the detected horizontal lines and the predicted horizontal lines is detected, the electronic device may generate an indoor map of the space in the form of the detected closed curve.

According to an embodiment, the electronic device may acquire the distance between adjacent vertices, based on the predicted position coordinates of the vertices 840, 841, 842, and 843.

According to an embodiment, the electronic device may acquire the distance between two adjacent vertices (or the length of a horizontal line connecting two vertices), based on the grid arranged on the floor plane.

FIG. 9A is a diagram illustrating a space recognition operation of an electronic device according to an embodiment.

FIG. 9B is a diagram illustrating a space recognition operation of an electronic device according to an embodiment.

Referring to FIG. 9A, an electronic device (e.g., the electronic device 101 in FIG. 1, the processor 120 in FIG. 1, the electronic device 101 in FIG. 2, or the processor 120 in FIG. 2) may capture images of areas of a space using a camera (e.g., the camera module 180 in FIG. 1 or the camera 180 in FIG. 2). For example, respective vertices and the entirety of one of a plurality of horizontal lines, which constitute the boundary between a floor and a wall, in a space may be occluded by a plurality of objects 910, 911, and 912.

According to an embodiment, when the electronic device is unable to detect a horizontal line in an area due to the object 912, the electronic device may detect a plurality of vertical lines 920, 921, 922, and 923 from the captured images. For example, the plurality of vertical lines 920, 921, 922, and 923 may be selected by the electronic device or by user input.

According to an embodiment, when the plurality of detected vertical lines 920, 921, 922, and 923 are not connected and partially occluded by the objects 910, 911, and 912 disposed at the vertices of the space, the electronic device may detect a floor area 930 included in the image, as illustrated in FIG. 9B. For example, the electronic device may detect the floor area 930, based on a change in the distance between the electronic device and an object (e.g., a floor or wall) using the stereo camera. According to an embodiment, the electronic device may predict the positions of intersections between the floor area 930 and the plurality of vertical lines 920, 921, 922, and 923 as the positions of the vertices 940, 941, 942, and 943.

For example, the electronic device may predict information (e.g., coordinate information of an intersection) related to the position of an intersection, based on the grid arranged on the floor plane.

For example, the electronic device may predict the position of an intersection between the extension line of a first vertical line 920 and the floor area 930 as the position of a first vertex 940 occluded by a first object 910.

For example, the electronic device may predict the position of an intersection between the extension line of a second vertical line 921 and the floor area 930 as the position of a second vertex 941 occluded by a second object 911.

For example, the electronic device may predict the position of an intersection between the extension line of a third vertical line 922 and the floor area 930 as the position of a third vertex 942 occluded by a third object 912.

For example, the electronic device may predict the position of an intersection of the extension line of a fourth vertical line 923 and the floor area 930 as the position of a fourth vertex 943 occluded by the third object 912.

According to an embodiment, the electronic device may predict the plurality of horizontal lines occluded by objects, based on the predicted positions of the vertices 910, 941, 942, and 943.

According to an embodiment, based on detecting a closed curve including the detected horizontal lines and the predicted horizontal lines, the electronic device may generate an indoor map (e.g., a floor plan) of the space, based on the detected horizontal lines and the predicted horizontal lines. For example, the indoor space may be defined as a closed curve in a polygonal shape, or a closed curve including curves. Accordingly, when a closed curve including the detected horizontal lines and the predicted horizontal lines is detected, the electronic device may generate an indoor map of the space in the form of the detected closed curve.

According to an embodiment, the electronic device may acquire the distance between adjacent vertices, based on the predicted position coordinates of the vertices 910, 941, 942, and 943.

According to an embodiment, an electronic device may acquire the distance between two adjacent vertices (or the length of a horizontal line connecting two vertices), based on the grid arranged on the floor plane.

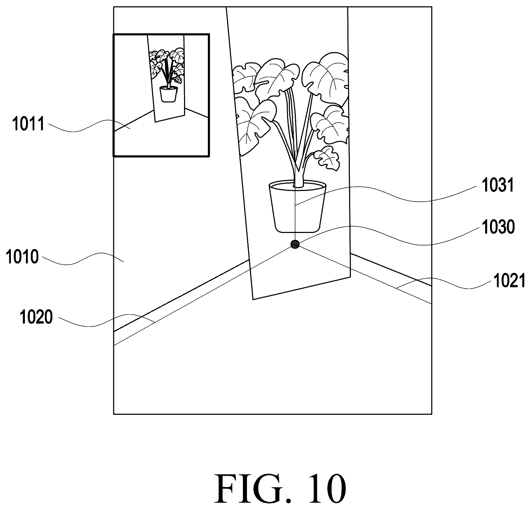

FIG. 10 is a diagram illustrating an operation of displaying a space recognition result of an electronic device according to an embodiment.

Referring to FIG. 10, an electronic device (e.g., the electronic device 101 in FIG. 1, the processor 120 in FIG. 1, the electronic device 101 in FIG. 2, or the processor 120 in FIG. 2) may display an image 1010 of a space captured by a camera (e.g., the camera module 180 in FIG. 1 or the camera 180 in FIG. 2) on a display (e.g., the display module 160 in FIG. 1 or the display 160 in FIG. 2).

According to an embodiment, the electronic device may display one or more horizontal lines 1020 and 1021 detected from the image 1010.

According to an embodiment, the electronic device may display a predicted intersection 1030, based on extension lines of one or more detected horizontal lines 1020 and 1021. For example, the intersection 1030 may be acquired using the extension lines of the plurality of horizontal lines 1020 and 1021, as illustrated in FIG. 7.

According to an embodiment, the electronic device may also display a predicted virtual vertical line 1031, based on the plurality of detected horizontal lines 1020 and 1021 and the predicted intersection 1030. According to an embodiment, the vertical line 1031 may be acquired so as to pass through the predicted intersection 1030 and be perpendicular to the horizontal lines 1020 and 1021, respectively.

According to an embodiment, the vertical line 1031 may be acquired so as to pass through the intersection 1030 and be perpendicular to the floor area.

According to an embodiment, the vertical line 1031 may be acquired so as to pass through the intersection 1030 and be parallel to a determined vertical line included in another area.

According to an embodiment, the electronic device may display only an image 1011 acquired by the camera in a portion of the display without displaying the lines.

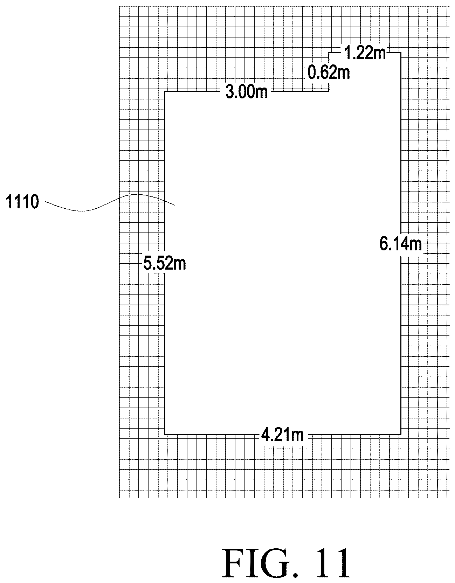

FIG. 11 is a diagram illustrating an operation of displaying an indoor map generated based on space recognition of an electronic device according to an embodiment.

Referring to FIG. 11, based on detecting a closed curve including detected horizontal lines and predicted horizontal lines, an electronic device (e.g., the electronic device 101 in FIG. 1, the processor 120 in FIG. 1, the electronic device 101 in FIG. 2, or the processor 120 in FIG. 2) may generate an indoor map 1110 (e.g., a floor plan) of a space, based on the detected horizontal lines and the predicted horizontal lines. For example, the indoor space may be defined as a closed curve in a polygonal shape, or a closed curve including curves. Accordingly, when a closed curve including the detected horizontal lines and the predicted horizontal lines is detected, the electronic device may generate an indoor map 1110 of the space in the form of the detected closed curve.

According to an embodiment, the electronic device may acquire the distance between adjacent vertices, based on the predicted position coordinates of the vertices.

According to an embodiment, the electronic device may acquire the distance between two adjacent vertices (or the length of a horizontal line connecting two vertices), based on the grid arranged on the floor plane.

According to an embodiment, the electronic device may display the indoor map 1110 including information (e.g., horizontal length and vertical length) related to the shape and area of the structure of the indoor space on a display (e.g., the display module 160 in FIG. 1 or the display 160 in FIG. 2).

In this way, even when only some of the space boundary, rather than the entire boundary, is captured using the camera, the structure of the space may be predicted, and a more accurate indoor map may be generated by receiving user input.

According to an embodiment, an electronic device may include a camera, a display, and at least one processor operatively connected to the camera and the display.

According to an embodiment, the at least one processor may acquire an image of a space captured through the camera.

According to an embodiment, the at least one processor may detect at least one of a horizontal line, which is a boundary between a wall and a floor included in the space, or a vertical line, which is a boundary between walls included in the space, based on the image,

According to an embodiment, the at least one processor may predict a position of a vertex of the space, based on at least one of the horizontal line or the vertical line, when the vertex is occluded by an object.

According to an embodiment, the at least one processor may generate an indoor map of the space, based on at least one of the horizontal line or the vertical line and the predicted position of the vertex.

According to an embodiment, the at least one processor may display at least one of the horizontal line or the vertical line.

According to an embodiment, the at least one processor, based on a plurality of horizontal lines being included in the image, may receive a user input for selecting one of the plurality of horizontal lines.

According to an embodiment, the at least one processor may generate the indoor map of the space, based on the selected first horizontal line.

According to an embodiment, the at least one processor may select a second horizontal line, based on at least one line detected in another area of the space, from among the plurality of horizontal lines.

According to an embodiment, the at least one processor may highlight the second horizontal line.

According to an embodiment, the at least one processor, based on the second horizontal line and the first horizontal line being different from each other, may remove the highlighting displayed on the second horizontal line and highlight the first horizontal line.

According to an embodiment, the at least one processor may display a message prompting movement to capture another area of the space after receiving the user input.

According to an embodiment, the at least one processor may predict extension lines of the horizontal lines or extension lines of the vertical lines.

According to an embodiment, the at least one processor may predict a position of an intersection of two or more of the extension lines of the horizontal lines or the extension lines of the vertical line as the position of the vertex.

According to an embodiment, the at least one processor may generate a virtual line, based on two or more of the horizontal lines or the vertical lines.

According to an embodiment, the at least one processor may predict extension lines of the horizontal lines or extension lines of the vertical lines.

According to an embodiment, the at least one processor may predict a position of an intersection between one of the extension lines of the horizontal lines or the extension lines of the vertical lines and the virtual line as the position of the vertex.

According to an embodiment, the at least one processor may detect a floor area included in the image.

According to an embodiment, the at least one processor may predict a position of an intersection between the floor area and the vertical line as the position of the vertex.

According to an embodiment, the at least one processor may predict a plurality of horizontal lines occluded by the object, based on the predicted position of the vertex.

According to an embodiment, the at least one processor, based on detecting a closed curve including the detected horizontal lines and the plurality of predicted horizontal lines, may generate an indoor map of the space, based on the detected horizontal lines and the plurality of predicted horizontal lines.

According to an embodiment, the at least one processor may receive a user input for selecting a shape of the space before capturing the space through the camera.

According to an embodiment, the camera may include a stereo camera.

According to an embodiment, the at least one processor may acquire length information of the horizontal lines, based on a captured image of the space acquired through the stereo camera.

According to an embodiment, a control method of an electronic device may include acquiring an image of a space captured through a camera of the electronic device.

According to an embodiment, the control method of an electronic device may include detecting at least one of a horizontal line, which is a boundary between a wall and a floor included in the space, or a vertical line, which is a boundary between walls included in the space, based on the image.

According to an embodiment, the control method of an electronic device may include predicting a position of a vertex of the space, based on at least one of the horizontal line or the vertical line, when the vertex is occluded by an object.

According to an embodiment, the control method of an electronic device may include generating an indoor map of the space, based on at least one of the horizontal line or the vertical line and the predicted position of the vertex.

According to an embodiment, the control method of an electronic device may further include displaying at least one of the horizontal line or the vertical line.

According to an embodiment, the control method of an electronic device may further include, based on a plurality of horizontal lines being included in the image, receiving a user input for selecting one of the plurality of horizontal lines.

According to an embodiment, the generating of an indoor map of the space may include generating the indoor map of the space, based on the selected first horizontal line.

According to an embodiment, the displaying of at least one of the horizontal line or the vertical line may include selecting a second horizontal line, based on at least one line detected in another area of the space, from among the plurality of horizontal lines.

According to an embodiment, the displaying of at least one of the horizontal line or the vertical line may include highlighting the second horizontal line.

According to an embodiment, the control method of an electronic device may further include, based on the second horizontal line and the first horizontal line being different from each other, removing the highlighting displayed on the second horizontal line and highlighting the first horizontal line.

According to an embodiment, the control method of an electronic device may further include displaying a message prompting movement to capture another area of the space after receiving the user input.

According to an embodiment, the predicting of the position of the vertex may include predicting extension lines of the horizontal lines or extension lines of the vertical lines.

According to an embodiment, the predicting of the position of the vertex may include predicting a position of an intersection of two or more of the extension lines of the horizontal lines or the extension lines of the vertical line as the position of the vertex.

According to an embodiment, the predicting of the position of the vertex may include generating a virtual line, based on two or more of the horizontal lines or the vertical lines.

According to an embodiment, the predicting of the position of the vertex may include predicting extension lines of the horizontal lines or extension lines of the vertical lines.

According to an embodiment, the predicting of the position of the vertex may include predicting a position of an intersection between one of the extension lines of the horizontal lines or the extension lines of the vertical lines and the virtual line as the position of the vertex.

According to an embodiment, the predicting of the position of the vertex may include detecting a floor area included in the image.

According to an embodiment, the predicting of the position of the vertex may include predicting a position of an intersection between the floor area and the vertical line as the position of the vertex.

According to an embodiment, the generating of the indoor map of the space may include predicting a plurality of horizontal lines occluded by the object, based on the predicted position of the vertex.

According to an embodiment, the generating of the indoor map of the space may include, based on detecting a closed curve including the detected horizontal lines and the plurality of predicted horizontal lines, generating the indoor map of the space, based on the detected horizontal lines and the plurality of predicted horizontal lines.

According to an embodiment, the control method of an electronic device may further include receiving a user input for selecting a shape of the space before capturing the space through the camera.

According to an embodiment, the camera may include a stereo camera.

According to an embodiment, the control method of an electronic device may further include acquiring length information of the horizontal lines, based on a captured image of the space acquired through the stereo camera.

According to an embodiment, in a non-transitory computer-readable recording medium storing one or more programs, the one or more programs may include instructions that cause an electronic device, wherein, according to an embodiment, the at least one processor, to acquire an image of a space captured through a camera of the electronic device.

According to an embodiment, the one or more programs may include instructions that cause the electronic device to detect at least one of a horizontal line, which is a boundary between a wall and a floor included in the space, or a vertical line, which is a boundary between walls included in the space, based on the image,

According to an embodiment, the one or more programs may include instructions that cause the electronic device to predict a position of a vertex of the space, based on at least one of the horizontal line or the vertical line, when the vertex is occluded by an object.

According to an embodiment, the one or more programs may include instructions that cause the electronic device to generate an indoor map of the space, based on at least one of the horizontal line or the vertical line and the predicted position of the vertex.

According to an embodiment, the one or more programs may include instructions that cause the electronic device to display at least one of the horizontal line or the vertical line.

According to an embodiment, the one or more programs may include instructions that cause the electronic device to receive, based on a plurality of horizontal lines being included in the image, a user input for selecting one of the plurality of horizontal lines.

According to an embodiment, the one or more programs may include instructions that cause the electronic device to generate the indoor map of the space, based on the selected first horizontal line.

According to an embodiment, the one or more programs may include instructions that cause the electronic device to select a second horizontal line, based on at least one line detected in another area of the space, from among the plurality of horizontal lines.

According to an embodiment, the one or more programs may include instructions that cause the electronic device to highlight the second horizontal line.

According to an embodiment, the one or more programs may include instructions that cause the electronic device to remove, based on the second horizontal line and the first horizontal line being different from each other, the highlighting displayed on the second horizontal line and highlight the first horizontal line.

According to an embodiment, the one or more programs may include instructions that cause the electronic device to display a message prompting movement to capture another area of the space after receiving the user input.

According to an embodiment, the one or more programs may include instructions that cause the electronic device to predict extension lines of the horizontal lines or extension lines of the vertical lines.

According to an embodiment, the one or more programs may include instructions that cause the electronic device to predict a position of an intersection of two or more of the extension lines of the horizontal lines or the extension lines of the vertical line as the position of the vertex.

According to an embodiment, the one or more programs may include instructions that cause the electronic device to generate a virtual line, based on two or more of the horizontal lines or the vertical lines.

According to an embodiment, the one or more programs may include instructions that cause the electronic device to predict extension lines of the horizontal lines or extension lines of the vertical lines.

According to an embodiment, the one or more programs may include instructions that cause the electronic device to predict a position of an intersection between one of the extension lines of the horizontal lines or the extension lines of the vertical lines and the virtual line as the position of the vertex.

According to an embodiment, the one or more programs may include instructions that cause the electronic device to detect a floor area included in the image.

According to an embodiment, the one or more programs may include instructions that cause the electronic device to predict a position of an intersection between the floor area and the vertical line as the position of the vertex.

According to an embodiment, the one or more programs may include instructions that cause the electronic device to predict a plurality of horizontal lines occluded by the object, based on the predicted position of the vertex.

According to an embodiment, the one or more programs may include instructions that cause the electronic device to generate, based on detecting a closed curve including the detected horizontal lines and the plurality of predicted horizontal lines, an indoor map of the space, based on the detected horizontal lines and the plurality of predicted horizontal lines.

According to an embodiment, the one or more programs may include instructions that cause the electronic device to receive a user input for selecting a shape of the space before capturing the space through the camera.

According to an embodiment, the camera may include a stereo camera.

According to an embodiment, the one or more programs may include instructions that cause the electronic device to acquire length information of the horizontal lines, based on a captured image of the space acquired through the stereo camera.

The electronic device according to an embodiment may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that an embodiment of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with an embodiment of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

An embodiment as set forth herein may be implemented as software (e.g., the program 240) including one or more instructions that are stored in a storage medium (e.g., internal memory 236 or external memory 238) that is readable by a machine (e.g., the electronic device 201). For example, a processor (e.g., the processor 220) of the machine (e.g., the electronic device 201) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to an embodiment of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to an embodiment, each component (e.g., a module or a program) of the above-described components may include a single entity or multiple entities, and some of the multiple entities may be separately disposed in different components. According to an embodiment, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to an embodiment, operations performed by the module, the program, or another component may be carried out sequentially, in parallel, repeatedly, or heuristically, or one or more of the operations may be executed in a different order or omitted, or one or more other operations may be added.

## Claims

1. An electronic device, comprising:
a camera;
a display; and
at least one processor operatively connected to the camera and the display,
wherein the at least one processor is configured to,
obtain an image of a space through the camera,
based on the image, detect at least one of a horizontal line or a vertical line, the horizontal line being a boundary between a wall and a floor which are included in the space, the vertical line being a boundary between walls included in the space,
when a vertex of the space is occluded by an object, predict a position of the vertex based on the at least one of the horizontal line or the vertical line; and
based on the position of the predicted vertex and the at least one of the horizontal line or the vertical line, generate an indoor map of the space.

2. The electronic device of claim 1,
wherein the at least one processor is further configured to,
display, through the display, the at least one of the horizontal line or the vertical line,
based on the image including a plurality of horizontal lines, receive a user input for selecting one among the plurality of horizontal lines, and
based on the selected first horizontal line, generate the indoor map of the space.

3. The electronic device of claim 2,
wherein the at least one processor is further configured to,
based on at least one line detected in another area of the space, select a second horizontal line among the plurality of horizontal lines,
display a highlight on the second horizontal line, and
based on the second horizontal line being different from the first horizontal line, delete the highlight displayed on the second horizontal line and highlight the first horizontal line.

4. The electronic device of any one of claims 2 or 3,
wherein the at least one processor is further configured to,
after receiving the user input, display, through the display, a message for inducing movement to capture an image of another area of the space.

5. The electronic device of any one of claims 1 to 4,
wherein the at least one processor is further configured to,
predict an extension of the horizontal line or an extension of the vertical line, and
predict a position of two or more intersections of the extension of the horizontal line or the extension of the vertical line, as the position of the vertex.

6. The electronic device of any one of claims 1 to 4,
wherein the at least one processor is further configured to,
based on two or more of the horizontal line or the vertical line, generate a virtual line,
predict an extension of the horizontal line or an extension of the vertical line, and
predict a position of an intersection of the extended line of the horizontal line or the extended line of the vertical line, and the virtual line as the position of the vertex.

7. The electronic device of any one of claims 1 to 4,
wherein the at least one processor is further configured to,
detect a floor area included in the image, and
predict a position of an intersection of the floor area and the vertical line as the position of the vertex.

8. The electronic device of any one of claims 1 to 7,
wherein the at least one processor is further configured to,
based on the predicted position of the vertex, predict a plurality of horizontal lines occluded by the object, and
based on detection of a closed curve including the detected horizontal line and the predicted plurality of horizontal lines, generate the indoor map of the space based on the detected horizontal line and the predicted plurality of horizontal lines.

9. The electronic device of any one of claims 1 to 8,
wherein the at least one processor is further configured to,
receive a user input for selecting a shape of the space before capturing an image of the space through the camera.

10. The electronic device of any one of claims 1 to 9,
wherein the camera includes a stereo camera, and
wherein the at least one processor is further configured to,
based on the image of the space obtained through the stereo camera, obtain length information of the horizontal line.

11. A control method of an electronic device, the method comprising:
acquiring an image of a space through a camera of the electronic device;
detecting at least one of a horizontal line, which is a boundary between a wall and a floor included in the space, or a vertical line, which is a boundary between walls included in the space, based on the image;
predicting a position of a vertex of the space, based on the at least one of the horizontal line or the vertical line, in a case where the vertex is occluded by an object; and
generating an indoor map of the space, based on the at least one of the horizontal line or the vertical line and the predicted position of the vertex.

12. The control method of an electronic device of claim 11, further comprising:
displaying the at least one of the horizontal line or the vertical line; and
based on a plurality of horizontal lines being included in the image, receiving a user input for selecting one of the plurality of horizontal lines,
wherein the generating of an indoor map of the space comprises, based on the selected first horizontal line, generating the indoor map of the space.

13. The control method of an electronic device of claim 12,
wherein the displaying of the at least one of the horizontal line or the vertical line further comprises:
based on at least one line detected in another area of the space, from among the plurality of horizontal lines, selecting a second horizontal line;
highlighting the second horizontal line; and
based on the second horizontal line and the first horizontal line being different from each other, removing the highlighting displayed on the second horizontal line and highlighting the first horizontal line.

14. The control method of an electronic device of claim 12 or 13, further comprising
displaying a message prompting movement to capture another area of the space after receiving the user input.

15. The control method of an electronic device of any one of claims 11 to 14,
wherein the predicting of the position of the vertex comprises:
predicting extension lines of the horizontal lines or extension lines of the vertical lines; and
predicting a position of an intersection of two or more of the extension lines of the horizontal lines or the extension lines of the vertical line as the position of the vertex.
